# EUROPEAN PATENT SPECIFICATION

(11) **EP 2 936 539 B1**
(45) Date of publication and mention of the grant of the patent: **22.02.2017**
(21) Application number: 13818465.0
(22) Date of filing: 18.12.2013
(51) Int. Cl.: H01J 37/32

(54) **IGNITION PROCESS AND DEVICE FOR PAIRS OF DBD ELECTRODES**
VERFAHREN UND VORRICHTUNG ZUM ZÜNDEN EINES DBD-ELEKTRODENPAARS
PROCÉDÉ ET DISPOSITIF D'ALLUMAGE POUR PAIRES D'ÉLECTRODES À DÉCHARGE À BARRIÈRE DIÉLECTRIQUE

(30) Priority: 21.12.2012 EP 12199066
(43) Date of publication of application: 28.10.2015
(73) Proprietor: Asahi Glass Company, Limited, Chiyoda-ku Tokyo 100-8405 (JP)
(72) Inventor: TIXHON, M. Eric, 4367 Crisnee (BE); MICHEL, M. Eric, 4000 Glain (BE); LECLERCQ, M. Joseph, 5600 Sart en Fagne (BE)
(74) Representative: Larangé, Françoise
(86) International application number: PCT/JP2013/007432
(87) International publication number: WO 2014/097620

(56) References cited:
- EP-A1- 1 796 442
- WO-A1-99/04411
- US-A1- 2010 112 235
- US-A1- 2012 199 286

## Description

### Field of the Invention

The invention relates to dielectric barrier discharge processes for the surface treatment of substrates. In particular, the invention concerns the ignition when the surface treatment is conducted by at least two electrodes and at least one counter-electrode positioned on either side of the substrate.

The invention also relates to an installation equipped with the ignition in question.

### Prior Art

A process for depositing layers onto a substrate by dielectric barrier discharge is known from document EP 2145978. The described process includes in particular the insertion or passage of a substrate in a reaction chamber, in which an electrode and a counter-electrode are positioned. A dielectric barrier is placed between this electrode and this counter-electrode. A high-frequency electric voltage that causes the generation of a plasma is generated between the electrode and the counter-electrode. A gaseous composition is fed into the reaction chamber that upon contact with the plasma reacts with the surface of the substrate. An adjustable inductance (L) arranged in parallel with the inductance of the installation generating the electric voltage is put into operation in order to reduce the phase shift between the voltage and the generated current and increase the passage time of the current in the plasma.

In the interest of increasing the efficiency of the process, it has already been envisaged to use two electrodes placed side by side, the current passing from these electrodes to corresponding counter-electrodes and the introduction of the reactive mixture thus occurring at the space separating the two electrodes. In such a process the virtually unavoidable consequence of small imperfections in the geometry of the electrodes and the counter-electrode or temperature differences is that the plasma preferably ignites under a single electrode. The resulting voltage at the terminals of the electrodes after ignition thus stabilises at the value of the discharge according to Paschen's law. This voltage no longer allows the ignition of the second electrode, since it is lower than the value of the sparkover voltage of the discharge. The result is that the injected reactive product is lost to 50% and the growth rate of the layer is slowed down in the same manner. Since it is impossible to form perfect electrodes and to compensate any temperature differences, to be able to ignite both electrodes a solution is to split the transformer supplying the system in order to provide a transformer for each electrode pair. This solution is not, of course, advantageous from the economic viewpoint since splitting of the transformer is costly.

Another solution described in WO 99/04411 is to use ballast inductances connected in series with each electrode. However, during operation after ignition of the two electrodes this assembly entails boosting the supply of the reactor.

US2012/0199286 discloses an installation for the surface treatment of a substrate by dielectric barrier discharge according to the preamble of claim 13.

### Summary of the Invention

An aim of the invention is to solve the ignition problem that classically arises in a DBD process using at least two electrodes arranged side by side to perform the surface treatment.

Another aim of the invention is to improve the efficiency and efficacy of such a process.

The invention relates to a process for surface treatment by dielectric barrier discharge comprising the following operations:
- feeding or passing a substrate into a reaction chamber, in which at least two electrodes and at least one counter-electrode are positioned, wherein at least one dielectric barrier is placed between these at least two electrodes and this at least one counter-electrode;
- generating a high-frequency electric voltage of such a value that it causes the generation of a plasma between these at least two electrodes and the at least one counter-electrode;
- feeding into the reaction chamber a mixture, the composition of which is such that on contact with the plasma, it breaks down and generates substances able to react with the surface of the substrate;
- connecting an inductance in series with each of said electrodes, wherein the value of said inductances is such that in the case where the plasma ignites under a single electrode, the current circulating in the inductance in series with this electrode causes a magnetic flux in the other inductance, and such that the resulting voltage at the terminals of this second inductance causes an increase in the voltage at the terminals of the electrode that remains unignited forcing the ignition thereof, wherein said inductances are wound on a common magnetic core so that the resulting magnetic flux of the two inductances is zero when identical currents circulate in the two electrodes.

It will be noted that the process of the invention is defined in terms of "operations" rather than "steps", i.e. that the succession of operations does not necessarily occur in the order in which they are outlined above.

"Surface treatment" is understood here to mean any operation for preparing, cleaning, coating or depositing one or more layers on the surface of a substrate.

There is thus defined an ignition device that is suitable for being connected in series on the at least two electrodes and comprises two inductances wound onto a common magnetic core having windings such that the magnetic fluxes produced by the two inductances cancel one another out when identical currents circulate in the two electrodes.

In the ignition device the value of the inductances (L1, L2) arranged in series with each of the electrodes is calculated such that when the plasma ignites under a single electrode, the current circulating in the inductance in series with this electrode causes a magnetic flux in the other inductance, and that the voltage resulting at the terminals of this second inductance causes an increase in the voltage at the terminals of the capacitor formed by the electrode that remains unignited and the corresponding counter-electrode.

When the two electrodes are ignited, the currents are balanced and the magnetic fluxes caused in the inductances assembled in series with the electrodes cancel one another out because the currents circulating across the two electrodes are essentially identical, which results in the impedances of these inductances being cancelled out. This characteristic is very important because when the assembly is started up, it is not necessary to boost the supply of the electrodes or to initiate any correction on the possible compensator coil.

The principle also applies in the same manner, mutatis mutandis, in the case where two pairs of electrodes are used.

The choice of value of the inductances is dependent on several functions, in particular the current between electrode and counter-electrode(s), wherein this current is itself dependent on the frequency and the geometry of said electrodes. Advantageously, if the voltage variation (dV) resulting from a preferred ignition at one of the electrodes causes a differential current (dI) with that of the electrode that remains unignited, the value of each inductance (1) will be such that dV = ω.l.dI, from which l = dV/ω.dI, with ω = 2πf and f is the frequency of the HF supply source.

According to an advantageous embodiment the winding of the inductances in series with each of said electrodes wound on a common magnetic core is reversed.

According to an advantageous embodiment the reactive mixture is fed via a passage into the reaction chamber opening into the space separating the two electrodes.

According to an advantageous embodiment the plasma is generated on either side of the substrate between the two electrodes and the counter-electrode and the reactive mixture fed into the reaction chamber is fed on either side of the substrate. Such a process allows a surface treatment to be achieved on each side of the substrate.

According to an advantageous embodiment the plasma is generated on either side of the substrate between the two electrodes and the counter-electrode and reactive mixtures of different compositions are fed into the reaction chamber on either side of the substrate. Such a process allows a different surface treatment to be achieved on each side of the substrate.

According to an advantageous embodiment the mixtures fed into the reaction chamber on either side of the substrate are confined in two separate zones by mechanical barriers. The substrate itself can be part of these mechanical barriers.

According to an advantageous embodiment two counter-electrodes facing the two electrodes are placed side by side in order to feed the reactive mixture via a passage into the reaction chamber opening onto the space separating the two counter-electrodes.

According to a preferred embodiment the process additionally comprises the following operations:
- putting into operation an adjustable inductance arranged in parallel with the inductance of the installation itself that generates the electric voltage in order to reduce the phase shift between the voltage and the current supplied by the HF source;
- adapting the voltage and/or the frequency supplied by the generator circuit and/or the adjustable value of the inductance at the start of or during the course of the process in order to obtain optimum reaction characteristics.

An advantage of this variant is that the introduction of an inductance into the circuit improves the power factor of the installation and hence increases its efficiency considerably. Another advantage of this variant is that it also allows the process to generate sufficient active energy to obtain elevated deposition rates while improving the properties of the deposited layers.

According to a preferred embodiment the voltage and/or the frequency supplied by the generator circuit and/or the value of the inductance are modulated in order to stimulate the production of harmonics that on each half-period extend the time, during which the voltage remains higher than the value of maintaining the arc, which results in extension of the generation time of the plasma. Harmonics in the order of 3 and 5 are preferably stimulated. An advantage of this embodiment is that with equal amount of power consumed, the efficacy of the process is substantially improved.

According to an advantageous embodiment the process additionally comprises the following operation: causing the position of the electrodes to vary in order to obtain optimum reaction characteristics. This can enable the characteristics of the electrical circuit to be varied and thus allow the configuration of the current to be influenced.

According to a particular embodiment the process additionally comprises the following operation: bringing the atmosphere prevailing in the chamber to a determined pressure that can be lower than atmospheric pressure.

Advantageously, the substrate is insulating and itself forms one of the dielectric barriers placed between the at least two electrodes.

Moreover, if the substrate is conductive, it can itself form one of the electrodes.

The mixture is fed into the reaction chamber preferably in the form of a liquid by spraying, of a reactive gas or powder.

The invention also relates to an installation for surface treatment by dielectric barrier discharge on a substrate comprising a chamber, transport means and support means for inserting a substrate into the chamber. A high-voltage and high-frequency power supply is connected to the two pairs of electrodes placed on either side of the substrate and at least one dielectric barrier is arranged between the at least two electrodes. Means for adjusting and controlling the power supply are provided, as are means for feeding reactive substances into the chamber and means for extracting background gases. In this installation an inductance is arranged in series with each pair of electrodes, wherein the value of these inductances is calculated to cause ignition of the second pair of electrodes, as explained above.

According to a preferred embodiment an adjustable inductance is arranged in parallel with the supply circuit. The characteristics of this adjustable inductance are such that it allows the phase shift between the voltage generated between the electrodes and the total current supplied by the high-voltage source to be modulated. In this installation the means for adjusting the power supply and the means for controlling the inductance are advantageously coupled in order to allow the generation of harmonics that at each half-period extend the time the value of the voltage between the electrodes is held at a value higher than that of maintaining the electric discharge.

According to an advantageous embodiment the chamber is open at its two ends, which allows the surface treatment process to be integrated into an installation for continuous production. For example, the chamber can advantageously be integrated into an annealing lehr of a float glass production line, wherein the support means for the substrate comprise at least one roller.

According to an advantageous embodiment the chamber is open at its two ends, which allows the surface treatment process to be integrated into an installation for continuous production. In this context, the chamber can advantageously be integrated into a float glass production line, wherein the support means for the substrate comprise a tin bath.

According to another preferred embodiment the chamber is closed, which allows the process of the invention to be integrated into a discontinuous surface treatment operation. The chamber can be positioned, for example, on " magnetron sputtering " treatment lines.

Advantageously the plasma can be generated in two separate zones arranged on either side of the substrate in such a manner that a layer is deposited onto each of the faces of this substrate simultaneously.

### Brief Description of the Figures

These aspects as well as other aspects of the invention will be clarified in the detailed description of particular embodiments of the invention with reference to the drawings of the figures, wherein:
Figure 1 is a schematic front view of an installation for depositing layers on a substrate;
Figure 2 is a schematic front view of an installation for depositing layers on both faces of a substrate;
Figure 3 is an equivalent circuit diagram of the installation before formation of the plasma in the case of a deposition on one of the two faces of the substrate or on both faces of the substrate;
Figure 4 is an equivalent circuit diagram of the installation after ignition of the plasma under one of the two electrodes in the case of a deposition on one of the two faces of the substrate or on both faces of the substrate;
Figure 5 is an equivalent circuit diagram of the installation after ignition of the plasma under both electrodes in the case of a deposition on one of the two faces of the substrate or on both faces of the substrate;
Figure 6 is an equivalent circuit diagram of the installation after ignition of the plasma under both electrodes in the case of a deposition on one of the two faces of the substrate or on both faces of the substrate according to another embodiment of the invention.
Figure 7 is a schematic front view of an installation for depositing layers on a substrate;

The figures are not drawn to scale. In general, similar elements are represented by similar references in the figures.

### Detailed Description of Particular Embodiments

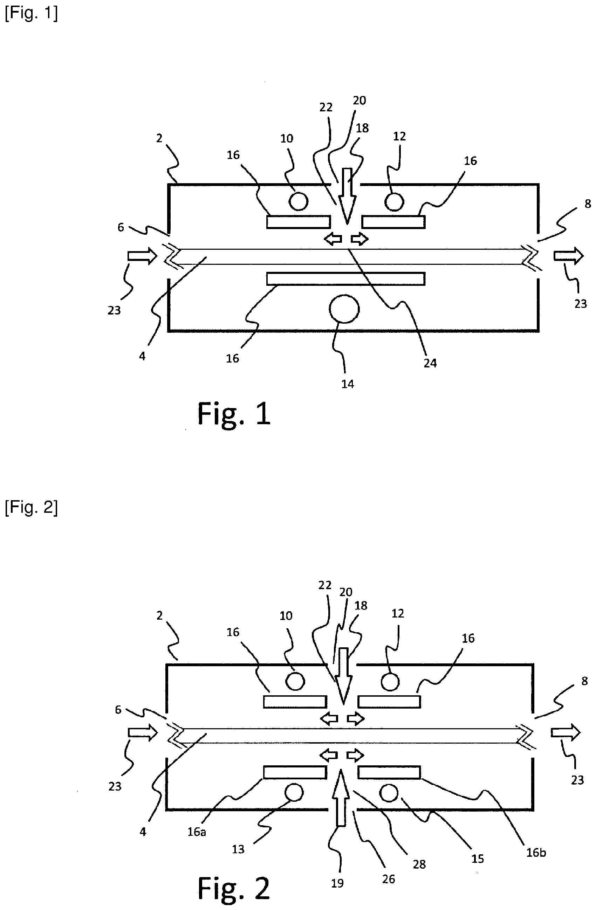

Figure 1 shows an open chamber 2 designed for a continuous process for depositing layers on a glass substrate. The glass substrate 4 is inserted through an inlet 6, then passes inside this deposition chamber 2 before exiting again through an outlet 8. A high-frequency high voltage is applied between two electrodes 10, 12 and a counter-electrode 14. A dielectric barrier 16 is placed between the two electrodes 10, 12 and the counter-electrode 14. The difference in potential between the two electrodes 10, 12 and the counter-electrode 14 causes the generation of a plasma. A reactive mixture 18 is fed into the deposition chamber 2. Using multiple electrodes, below which the substrate 4 passes successively, results in the total surface area of the electrodes being increased. Compared to a process that only uses one electrode and one counter-electrode, this allows the thickness of the deposit to be increased or, alternatively with an identical thickness of deposit, allows the passage rate of the substrate inside the chamber to be increased. In practice, in the case of using two electrodes 10, 12 facing a counter-electrode 14, the reactive mixture 18 is ideally fed through a passage 20 into the deposition chamber 2 opening into the space 22 separating the two electrodes 10, 12. This allows an ideal and rapid distribution of reactive ions 18 in the deposition zone 24. The arrows 23 indicate the direction of passage of the glass substrate 4.

Figure 2 shows that it is also possible to conduct a deposition simultaneously on both faces of the glass substrate 4. In such a process the counter-electrode 14 of the previous assembly is replaced by a double counter-electrode formed from two counter-electrodes 13, 15 and the dielectric barrier 16 is replaced by a double dielectric barrier formed by two dielectric barriers 16a and 16b. The introduction of reactive gases 18, 19 occurs in this case through passages 20, 26 in the deposition reaction chamber 2 formed on either side of the substrate 4 opening onto the spaces 22, 28 that respectively separate the two electrodes and the two counter-electrodes.

The voltage applied between the electrodes and the counter-electrode or counter-electrodes is preferably in the range of between 1000 and 200 000 V peak to peak, more preferred between 5000 and 100 000 V peak to peak, and still more preferred between 10 000 and 40 000 V peak to peak. The frequency is preferably in the range of between 10 KHz and 1000 KHz, more preferred between 20 KHz and 400 KHz and still more preferred between 50 KHz and 200 KHz.

The electrodes and counter-electrodes of figures 1 and 2 have been drawn as cylindrical electrodes, but may alternatively be flat.

As explained above, the use of two electrodes 10, 12 in the processes described in Figure 1 and Figure 2 causes an ignition problem resulting from the fact that if the two electrodes are not ignited simultaneously, after ignition of the first electrode the voltage applied between the electrode that remains unignited and the counter-electrode or counter-electrodes 13, 14, 15 is no longer sufficient to ignite this second electrode. To resolve this problem a device comprising two identical coils wound onto a common magnetic core has been conceived. Each of the coils is connected in series with one of the electrodes 10, 12 and the winding of the two coils around the common magnetic core is performed to obtain two fluxes that cancel one another out as soon as both electrodes are ignited. This characteristic is highly advantageous because as soon as the assembly has started up, it is not necessary to boost the supply of the electrodes or to initiate any correction on the possible compensator coil.

In the ignition device the value of the inductances (L1, L2) arranged in series with each of the electrodes is calculated such that when the plasma ignites under a single electrode, the current circulating in the inductance in series with this electrode causes a magnetic flux in the other inductance, and that the voltage resulting at the terminals of this second inductance causes an increase in the voltage at the terminals of the capacitor formed by the electrode that remains unignited and the corresponding counter-electrode.

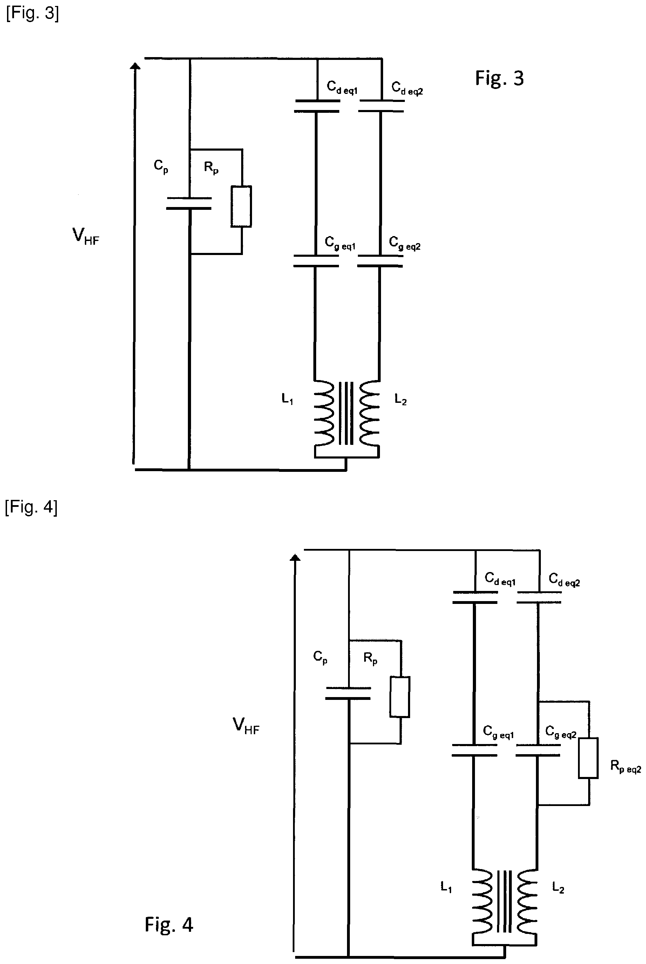

A highly simplified equivalent circuit diagram of the installation before start-up equipped with the device for forcing the ignition of the plasma under the two electrodes is shown in Figure 3. A high-frequency (HF) high voltage is applied between the electrodes and the counter-electrode or counter-electrodes. The installation for discharge in the chamber amounts essentially to an addition of capacitors in parallel and in series, i.e. Cp (parasitic capacitance in parallel with a parasitic resistance Rp), Cd eq1, Cd eq2 (capacitance of the dielectric or dielectrics) and Cg eq1, Cg eq2 (capacitance of the gas or gases). L1 and L2 correspond to the inductances of the device to force the ignition of the plasma under both electrodes.

Figure 4 shows the same diagram when the plasma is generated under a single electrode. At this instant, Cg eq2 is shunted by a resistance Rg eq2, which represents the resistance of the plasma under the first electrode.

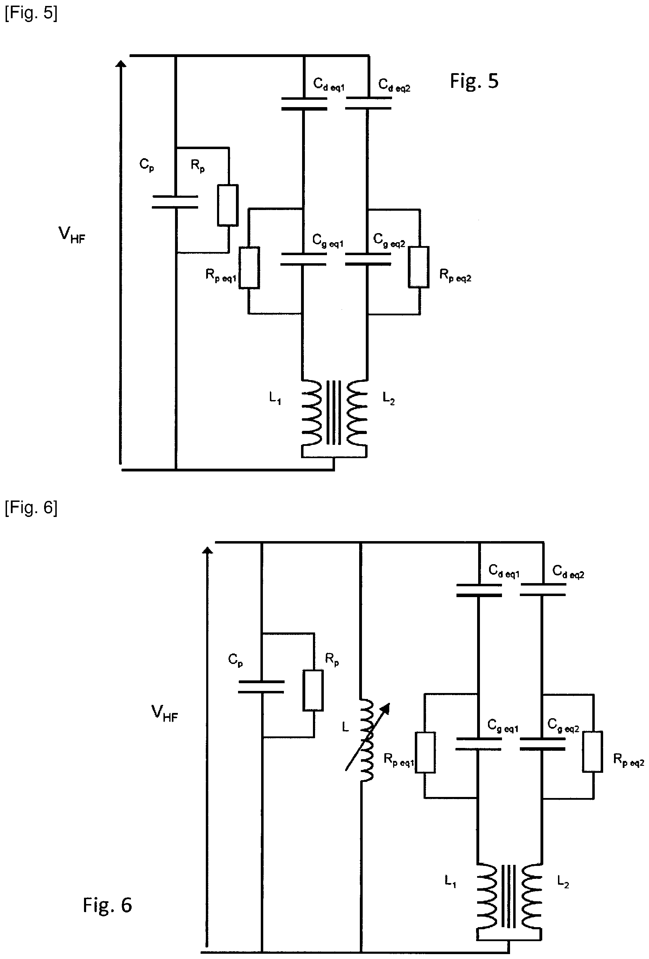

Figure 5 shows the same diagram again, but this time when the plasma is also generated under the second electrode under the action of the ignition device formed by L1 and L2. At this instant, Cg eq1 is shunted by a resistance Rg eq1, which represents the resistance of the plasma under the second electrode.

In the absence of discharge (i.e. as long as the voltage applied between the electrodes and the counter-electrode or counter-electrodes is lower than the sparkover voltage), the values of Rg eq1 and Rg eq2 are extremely high, which explains why it is not necessary to take them into consideration in circuits modelling the system in the absence of discharge and the total current supplied by the source is practically solely capacitive. During the course of the discharge resistive currents Ig1 and Ig2 appear under each electrode and are the electrical sign of the deposit conducted on the substrate.

Figure 6 shows the equivalent circuit diagram of the routine operation of a surface treatment installation according to the invention, in which an adjustable inductance (L) arranged in parallel with the inductance of the installation itself that generates the electric voltage is put into operation. The value for the adjustable inductance (L) is chosen in order to reduce the phase shift between the voltage and the current supplied by the HF source. The insertion of this inductance into the circuit improves the power factor of the installation and hence increases its efficiency considerably. It will be evident to a person skilled in the art that the present invention is not limited to the examples illustrated and described above. The invention is defined by the claims. The presence of reference numbers cannot be considered as restrictive. The use of the term "comprises" cannot in any way exclude the presence of elements other than those mentioned. The use of the indefinite article "a" to introduce an element does not exclude the presence of a plurality of these elements. The present invention has been described in relation to specific embodiments, which are of purely illustrative value and must not be considered as restrictive.

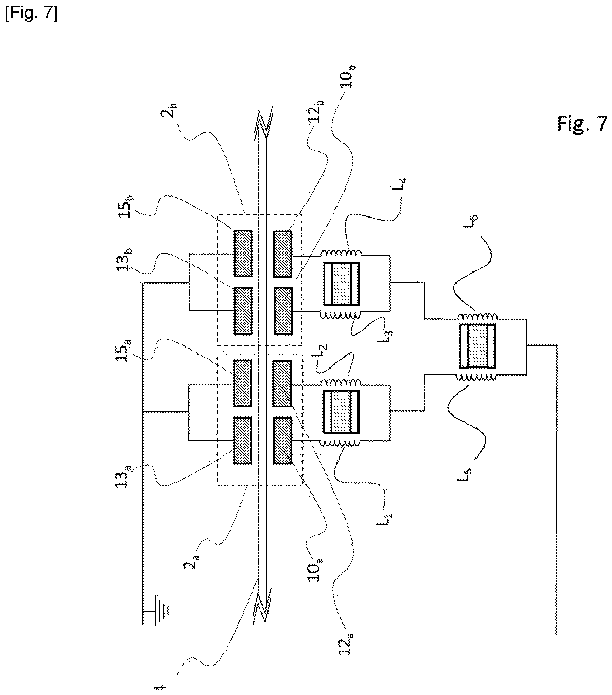

Figure 7 shows another installation for the surface treatment of a substrate according to the present invention comprising two chambers 2a, 2b designed for a continuous process for depositing layers on a glass substrate 4. Such an installation can offer the possibility of, for example, successively coating a substrate with two layers of different nature, or first treat the substrate, then deposit a coating on it, or coating the substrate with a thicker coating. In the embodiment of figure 7, an installation for the surface treatment of a substrate as described hereinabove is doubled: (i) a first sub-installation comprising chamber 2a and primary inductances L1, L2 switched in series with each of said electrodes 10a, 12a, and (ii) a second sub-installation comprising chamber 2b and primary inductances L3, L4 switched in series with each of said electrodes 10b, 12b. Counter-electrodes are denoted 13a, 15a and 13b, 15b. These two sub-installations are supplied with a single VHF or HF source and secondary inductances L5 and L6 allow equilibrate the currents in both chambers 2a and 2b (by "equilibrate the currents", we mean having substantially identical currents at the entrance of both chambers, i.e. at the entrance of the primary inductances). L1, L2 and L3, L4 allow, as hereinabove described, equilibrate the currents and force the ignition of the plasma under each pair of electrodes in their respective chamber. This embodiment shows that a device comprising a double inductance system as described hereinabove for an installation with two pairs of electrodes may also apply to solve the ignition of two sub-installations each having two pairs of electrodes but supplied with a single HF source.

In the example of figure 7, it was chosen to:
- use the glass substrate as dielectric barrier, therefore, no other dielectric barrier was included between the electrodes and counter-electrodes
- draw the electrodes and counter-electrodes as "flat" electrodes.

If such an installation is used to coat the substrate, the coating will be formed on the lower face of glass substrate 4.

## Claims

1. A process for surface treatment by dielectric barrier discharge (DBD) comprising the following operations:
- feeding or passing a substrate into a reaction chamber (2), in which two electrodes (10, 12) and at least one counter-electrode (13, 14, 15) are positioned, wherein at least one dielectric barrier (16) is placed between these two electrodes (10, 12) and this at least one counter-electrode (13, 14, 15);
- generating a high-frequency electric voltage of such a value that it causes the generation of a plasma between the two electrodes (10, 12) and the at least one counter-electrode (13, 14, 15);
- feeding into the reaction chamber a mixture, the composition of which is such that on contact with the plasma, it breaks down and generates substances able to react with the surface of the substrate (4);
**characterised in that** it additionally comprises the following operation:
- connecting an inductance (L1, L2) in series with each of said electrodes (10, 12), wherein the value of said inductances (L1, L2) is such that in the case where the plasma ignites under a single electrode, the current circulating in the inductance in series with this electrode causes a magnetic flux in the other inductance, and such that the resulting voltage at the terminals of this second inductance causes an increase in the voltage at the terminals of the electrode that remains unignited forcing the ignition thereof, wherein said inductances are wound on a common magnetic core so that the resulting magnetic flux of the two inductances (L1, L2) is zero when identical currents circulate in the two electrodes (10, 12).

2. Process according to claim 1, **characterised in that** the winding of the inductances (L1, L2) in series with each of said electrodes (10, 12) wound on a common magnetic core is reversed.

3. Process according to one of the preceding claims, **characterised in that** the mixture fed into the reaction chamber is fed via a passage (20) opening into the space (22) separating the two electrodes (10, 12).

4. Process according to one of the preceding claims, **characterised in that** the plasma is generated on either side of the substrate (4) between the two electrodes (10, 12) and the at least one counter-electrode (13, 14, 15) in order to achieve a surface treatment on each side of the substrate (2).

5. Process according to claim 4, **characterised in that** reactive mixtures (18, 19) of different compositions are fed into the reaction chamber (2) on either side of the substrate (4) in order to achieve a different surface treatment on each side of the substrate (4).

6. Process according to one of the preceding claims, **characterised in that** two counter-electrodes (13, 15) facing the two electrodes (10, 12) are placed side by side and that the reactive mixture (19) is fed via a passage (26) into the reaction chamber opening onto the space (28) separating the two counter-electrodes (13, 15).

7. Process according to one of the preceding claims, **characterised in that** it additionally comprises the following operations:
- putting into operation an adjustable inductance (L) arranged in parallel with the inductance of the installation itself that generates the electric voltage in order to reduce the phase shift between the voltage and the generated current;
- adapting the voltage and/or the frequency supplied by the generator circuit and/or the adjustable value (L) of the inductance at the start of or during the course of the process in order to increase the active power/reactive power ratio.

8. Process according to claim 7, **characterised in that** it additionally comprises the following operation:
- adapting the voltage and/or the frequency supplied by the generator circuit and/or the adjustable value (L) of the inductance in order to stimulate the production of harmonics that extend the time, during which the voltage remains higher than the value of maintaining the electric discharge.

9. Process according to claim 8, **characterised in that** harmonics in the order of 3 and 5 are essentially stimulated.

10. Process according to any one of the preceding claims, **characterised in that** it additionally comprises the following operation:
- bringing the atmosphere prevailing in the chamber to a pressure lower than atmospheric pressure.

11. Process according to any one of the preceding claims, **characterised in that** the chamber (2) is open and comprises an inlet zone and an outlet zone for the substrate (4).

12. Process according to any one of the preceding claims, **characterised in that** the substrate (4) is insulating and itself forms at least one of the dielectric barriers (16).

13. Installation adapted to the surface treatment of a substrate (4) by dielectric barrier discharge (DBD) comprising a chamber (2), transport means and support means for inserting the substrate (4) into the chamber, a high-voltage and high-frequency power supply, two electrodes (10, 12) and at least one counter-electrode (13, 14, 15), wherein said power supply is connected to said two electrodes (10, 12) and to said at least one counter-electrode (13, 14, 15), wherein said two electrodes (10, 12) and said at least one counter-electrode (13, 14, 15) are arranged on either side of the transport and support means of the substrate (4), at least one dielectric barrier (16, 16a, 16b) arranged between the two electrodes (10, 12) and the at least one counter-electrode (13, 14, 15), means for adjusting and controlling the power supply, means for feeding reactive substances into the chamber (2), means for extracting background substances, wherein this installation is adapted to generate a plasma for the surface treatment of the substrate (4), **characterised in that** the installation further comprises two inductances (L1, L2), each of the inductances being switched in series with each of said two electrodes (10, 12), wherein the value of said inductances (L1, L2) is such that in the case where the plasma ignites under a single electrode, the current circulating in the inductance in series with this electrode causes a magnetic flux in the other inductance, and such that the resulting voltage at the terminals of this second inductance causes an increase in the voltage at the terminals of the electrode that remains unignited forcing the ignition thereof, wherein said two inductances are wound on a common magnetic core so that the resulting magnetic flux of the two inductances is zero when identical currents circulate in the two electrodes.

14. Surface treatment installation according to claim 13, **characterised in that** the plasma is generated in two separate zones arranged on either side of the substrate in such a manner that a treatment is conducted on each of the faces of this substrate (2) simultaneously.

15. Installation adapted to the surface treatment of a substrate (4) by dielectric barrier discharge (DBD) comprising two chambers (2a, 2b), each chamber comprising two electrodes (10a, 12a, 10b, 12b) and at least one counter-electrode (13a, 15a, 13b, 15b), transport the means and support means for inserting the substrate (4) into the chambers, a single high-voltage and high-frequency power supply connected to said electrodes (10a, 12a) and to said at least one counter-electrode (13a, 15a) in the first chamber (2a), and to said two electrodes (10b, 12b) and to said at least one counter-electrode (13b, 15b) in the second chamber (2b), wherein said four electrodes (10a, 12a, 10b, 12b) and said at least two counter-electrodes (13a, 15a, 13b, 15b) are arranged on either side of the transport and support means of the substrate (2), at least one dielectric barrier arranged between the four electrodes (10a, 12a, 10b, 12b) and the at least two counter-electrodes (13a, 15a, 13b, 15b), means for adjusting and controlling the power supply, means for feeding reactive substances into the chambers, means for extracting background substances, wherein this installation is adapted to generate a plasma for the surface treatment of the substrate (4) in each chamber, wherein the installation further comprises primary (L1, L2 and L3, L4) and secondary (L5, L6) inductances such that, for each chamber separately, each of said primary inductances (L1, L2 and L3, L4) are switched in series with each of said electrodes, wherein the value of said primary inductances (L1, L2 and L3, L4) is such that in the case where the plasma ignites under a single electrode, the current circulating in the primary inductance in series with this electrode causes a magnetic flux in the other primary inductance, and such that the resulting voltage at the terminals of this other primary inductance causes an increase in the voltage at the terminals of the electrode that remains unignited forcing the ignition thereof, wherein said primary inductances are wound on a common magnetic core so that the resulting magnetic flux of the two primary inductances is zero when identical currents circulate in the two electrodes, and wherein said secondary inductances (L5, L6) are switched in series with said primary inductances, wherein the value of said additional secondary inductances (L5, L6) is such that the current circulating in the first secondary inductance in series with the first chamber causes a magnetic flux in the other secondary inductance, and such that the resulting voltage at the terminals of this other secondary inductance ensures equilibrate the voltages between the two chambers, wherein said secondary inductances are wound on a common magnetic core so that the resulting magnetic flux of the two secondary inductances is zero when identical currents circulate in the two chambers.

## Patentansprüche

1. Prozess für Oberflächenbehandlung durch dielektrische Barriereentladung (DBE), umfassend die folgenden Operationen:
- Einführen oder Schicken eines Substrats in eine Reaktionskammer (2), in der zwei Elektroden (10, 12) und mindestens eine Gegenelektrode (13, 14, 15) positioniert sind, wobei mindestens eine dielektrische Barriere (16) zwischen diesen beiden Elektroden (10, 12) und dieser mindestens einen Gegenelektrode (13, 14, 15) platziert ist;
- Generieren einer hochfrequenten elektrischen Spannung mit einem derartigen Wert, dass er die Generierung eines Plasmas zwischen den zwei Elektroden (10, 12) und der mindestens einen Gegenelektrode (13, 14, 15) bewirkt;
- Einführen in die Reaktionskammer einer Mischung, deren Zusammensetzung derart ist, dass sie sich bei Kontakt mit dem Plasma zersetzt und Substanzen generiert, die in der Lage sind, mit der Oberfläche des Substrats (4) zu reagieren,
**dadurch gekennzeichnet, dass** er zusätzlich die folgende Operation umfasst:
- Schalten einer Induktanz (L1, L2) in Reihe mit jeder der Elektroden (10, 12), wobei der Wert der Induktanzen (L1, L2) derart ist, dass im Fall, dass das Plasma unter einer einzelnen Elektrode zündet, der in der Induktanz in Reihe mit dieser Elektrode zirkulierende Strom einen Magnetfluss in der anderen Induktanz bewirkt, und derart, dass die resultierende Spannung an den Anschlüssen dieser zweiten Induktanz eine Erhöhung der Spannung an den Anschlüssen der Elektrode bewirkt, die ungezündet bleibt, was deren Zündung erzwingt, wobei die Induktanzen so auf einen gemeinsamen Magnetkern gewickelt sind, dass der resultierende Magnetfluss der beiden Induktanzen (L1, L2) null ist, wenn identische Ströme in den beiden Elektroden (10, 12) zirkulieren.

2. Prozess nach Anspruch 1, **dadurch gekennzeichnet, dass** die Wicklung der Induktanzen (L1, L2) in Reihe mit jeder der Elektroden (10, 12), auf einem gemeinsamen Magnetkern gewickelt, umgekehrt ist.

3. Prozess nach einem der vorhergehenden Ansprüche, **dadurch gekennzeichnet, dass** die in die Reaktionskammer eingeführte Mischung über eine Passage (20) eingeführt wird, die in den Raum (22) mündet, der die beiden Elektroden (10, 12) trennt.

4. Prozess nach einem der vorhergehenden Ansprüche, **dadurch gekennzeichnet, dass** das Plasma auf beiden Seiten des Substrats (4) zwischen den beiden Elektroden (10, 12) und der mindestens einen Gegenelektrode (13, 14, 15) generiert wird, um eine Oberflächenbehandlung auf jeder Seite des Substrats (2) zu erzielen.

5. Prozess nach Anspruch 4, **dadurch gekennzeichnet, dass** reaktive Mischungen (18, 19) mit unterschiedlichen Zusammensetzungen in die Reaktionskammer (2) auf beiden Seiten des Substrats (4) eingeführt werden, um eine andere Oberflächenbehandlung auf jeder Seite des Substrats (4) zu erzielen.

6. Prozess nach einem der vorhergehenden Ansprüche, **dadurch gekennzeichnet, dass** zwei den beiden Elektroden (10, 12) zugewandte Gegenelektroden (13, 15) Seite an Seite platziert werden und dass die reaktive Mischung (19) über eine Passage (26) in die Reaktionskammer eingeführt wird, die in den Raum (28) mündet, der die beiden Gegenelektroden (13, 15) trennt.

7. Prozess nach einem der vorhergehenden Ansprüche, **dadurch gekennzeichnet, dass** er zusätzlich die folgenden Operationen umfasst:
- Inbetriebsetzen einer justierbaren Induktanz (L) parallel mit der Induktanz der Installation selbst angeordnet, die die elektrische Spannung generiert, um die Phasenverschiebung zwischen der Spannung und dem generierten Strom zu reduzieren;
- Anpassen der durch die Generatorschaltung und/oder den justierbaren Wert (L) der Induktanz gelieferten Spannung und/oder Frequenz beim Start oder während des Verlaufs des Prozesses, um das Verhältnis Wirkleistung/Blindleistung zu erhöhen.

8. Prozess nach Anspruch 7, **dadurch gekennzeichnet, dass** er zusätzlich die folgende Operation umfasst:
- Anpassen der durch die Generatorschaltung und/oder den justierbaren Wert (L) der Induktanz gelieferten Spannung und/oder Frequenz, um die Produktion von Oberwellen zu stimulieren, die die Zeit verlängern, während der die Spannung höher bleibt als der Wert des Aufrechterhaltens der elektrischen Entladung.

9. Prozess nach Anspruch 8, **dadurch gekennzeichnet, dass** Oberwellen der Ordnung von 3 und 5 im Wesentlichen stimuliert werden.

10. Prozess nach einem der vorhergehenden Ansprüche, **dadurch gekennzeichnet, dass** er zusätzlich die folgende Operation umfasst:
- Bringen der in der Kammer vorherrschenden Atmosphäre auf einen Druck unter atmosphärischen Druck.

11. Prozess nach einem der vorhergehenden Ansprüche, **dadurch gekennzeichnet, dass** die Kammer (2) offen ist und eine Einlasszone und eine Auslasszone für das Substrat (4) umfasst.

12. Prozess nach einem der vorhergehenden Ansprüche, **dadurch gekennzeichnet, dass** das Substrat (4) isolierend ist und selbst mindestens eine der dielektrischen Barrieren (16) bildet.

13. Installation, ausgelegt auf die Oberflächenbehandlung eines Substrats (4) durch dielektrische Barriereentladung (DBE), umfassend eine Kammer (2), Transportmittel und Stützmittel zum Einbringen des Substrats (4) in die Kammer, eine Hochspannungs- und Hochfrequenz-Stromversorgung, zwei Elektroden (10, 12) und mindestens eine Gegenelektrode (13, 14, 15), wobei die Stromversorgung mit den beiden Elektroden (10, 12) und mit der mindestens einen Gegenelektrode (13, 14, 15) verbunden ist, wobei die beiden Elektroden (10, 12) und die mindestens eine Gegenelektrode (13, 14, 15) auf beiden Seiten des Transport- und Stützmittels des Substrats (4) angeordnet sind, mindestens eine dielektrische Barriere (16, 16a, 16b), zwischen den beiden Elektroden (10, 12) und der mindestens einen Gegenelektrode (13, 14, 15) angeordnet, Mittel zum Justieren und Steuern der Stromversorgung, Mittel zum Einführen reaktiver Substanzen in die Kammer (2), Mittel zum Extrahieren von Hintergrundsubstanzen, wobei diese Installation ausgelegt ist zum Generieren eines Plasmas für die Oberflächenbehandlung des Substrats (4),
**dadurch gekennzeichnet, dass** die Installation weiterhin zwei Induktanzen (L1, L2) umfasst, wobei jede der Induktanzen in Reihe mit jeder der zwei Elektroden (10, 12) geschaltet ist,
wobei der Wert der Induktanzen (L1, L2) derart ist, dass im Fall, dass das Plasma unter einer einzelnen Elektrode zündet, der in der Induktanz in Reihe mit dieser Elektrode zirkulierende Strom einen Magnetfluss in der anderen Induktanz bewirkt, und derart, dass die resultierende Spannung an den Anschlüssen dieser zweiten Induktanz eine Erhöhung der Spannung an den Anschlüssen der Elektrode bewirkt, die ungezündet bleibt, was deren Zündung erzwingt, wobei die beiden Induktanzen so auf einen gemeinsamen Magnetkern gewickelt sind, dass der resultierende Magnetfluss der beiden Induktanzen null ist, wenn identische Ströme in den beiden Elektroden zirkulieren.

14. Oberflächenbehandlungsinstallation nach Anspruch 13, **dadurch gekennzeichnet, dass** das Plasma in zwei separaten Zonen generiert wird, die derart auf beiden Seiten des Substrats angeordnet sind, dass eine Behandlung an jeder der Flächen dieses Substrats (2) simultan durchgeführt wird.

15. Installation, ausgelegt für die Oberflächenbehandlung eines Substrats (4) durch dielektrische Barriereentladung (DBE), umfassend zwei Kammern (2a, 2b), wobei jede Kammer zwei Elektroden (10a, 12a, 10b, 12b) und mindestens eine Gegenelektrode (13a, 15a, 13b, 15b) umfasst, Transportmittel und Stützmittel zum Einbringen des Substrats (4) in die Kammern, eine einzelne Hochspannungs- und Hochfrequenz-Stromversorgung, mit den Elektroden (10a, 12a) und mit der mindestens einen Gegenelektrode (13a, 15a) in der ersten Kammer (2a) und mit den beiden Elektroden (10b, 12b) und der mindestens einen Gegenelektrode (13b, 15b) in der zweiten Kammer (2b) verbunden, wobei die vier Elektroden (10a, 12a, 10b, 12b) und die mindestens zwei Gegenelektroden (13a, 15a, 13b, 15b) auf beiden Seiten des Transport- und Stützmittels des Substrats (2) angeordnet sind, wobei mindestens eine dielektrische Barriere zwischen den vier Elektroden (10a, 12a, 10b, 12b) und den mindestens zwei Gegenelektroden (13a, 15a, 13b, 15b) angeordnet ist, Mittel zum Justieren und Steuern der Stromversorgung, Mittel zum Einführen von reaktiven Substanzen in die Kammern, Mittel zum Extrahieren von Hintergrundsubstanzen, wobei die Installation ausgelegt ist zum Generieren eines Plasmas für die Oberflächenbehandlung des Substrats (4) in jeder Kammer,
wobei die Installation weiterhin primäre (L1, L2 und L3, L4) und sekundäre (L5, L6) Induktanzen derart umfasst, dass für jede Kammer separat jede der primären Induktanzen (L1, L2 und L3, L4) in Reihe mit jeder der Elektroden geschaltet sind, wobei der Wert der primären Induktanzen (L1, L2 und L3, L4) derart ist, dass im Fall, dass das Plasma unter einer einzelnen Elektrode zündet, der in der primären Induktanz in Reihe mit dieser Elektrode zirkulierende Strom einen Magnetfluss in der anderen primären Induktanz bewirkt, und derart, dass die resultierende Spannung an den Anschlüssen dieser anderen primären Induktanz eine Erhöhung der Spannung an den Anschlüssen der Elektrode bewirkt, die ungezündet bleibt, was deren Zündung erzwingt, wobei die primären Induktanzen so auf einen gemeinsamen Magnetkern gewickelt sind, dass der resultierende Magnetfluss der beiden primären Induktanzen null ist, wenn identische Ströme in den beiden Elektroden zirkulieren,
und wobei die sekundären Induktanzen (L5, L6) in Reihe mit den primären Induktanzen geschaltet sind, wobei der Wert der zusätzlichen sekundären Induktanzen (L5, L6) derart ist, dass der Strom, der in der ersten sekundären Induktanz in Reihe mit der ersten Kammer zirkuliert, einen Magnetfluss in der anderen sekundären Induktanz bewirkt, und derart, dass die resultierende Spannung an den Anschlüssen dieser anderen sekundären Induktanz ein Ausgleichen der Spannungen zwischen den beiden Kammern sicherstellt, wobei die sekundären Induktanzen so auf einen gemeinsamen Magnetkern gewickelt sind, dass der resultierende Magnetfluss der beiden sekundären Induktanzen null ist, wenn in den beiden Kammern identische Ströme zirkulieren.

## Revendications

1. Procédé de traitement de surface par décharge à barrière diélectrique (DBD) comprenant les opérations suivantes :
- introduire ou faire défiler un substrat dans une chambre de réaction (2) dans laquelle sont placées deux électrodes (10, 12) et au moins une contre-électrode (13, 14, 15), au moins une barrière diélectrique (16) étant placée entre ces deux électrodes (10, 12) et cette au moins une contre-électrode (13, 14, 15);
- engendrer une tension électrique à haute fréquence de valeur telle qu'elle entraîne la génération d'un plasma entre les deux électrodes (10, 12) et l'au moins une contre-électrode (13, 14, 15);
- introduire dans la chambre de réaction un mélange dont la composition est telle qu'au contact du plasma, il se décompose et engendre des espèces aptes à réagir avec la surface du substrat (4);
**caractérisé en ce qu'**il comprend en outre l'opération suivante :
brancher une inductance (L1, L2) en série avec chacune desdites électrodes (10, 12), la valeur desdites inductances (L1, L2) étant telle que dans le cas où le plasma s'allume sous une seule électrode, le courant circulant dans l'inductance en série avec cette électrode induise un flux magnétique dans l'autre inductance, et que la tension en résultant aux bornes de cette seconde inductance provoque une augmentation de la tension aux bornes de l'électrode restée éteinte forçant l'allumage de celle-ci, lesdites inductances étant bobinées sur un noyau magnétique commun de manière à ce que le flux magnétique résultant des deux inductances (L1, L2) soit nul lorsque des courants identiques circulent dans les deux électrodes (10, 12).

2. Procédé selon la revendication 1, **caractérisé en ce que** l'enroulement des inductances (L1, L2) en série avec chacune desdites électrodes (10, 12) bobinées sur un noyau magnétique commun est inversé.

3. Procédé selon l'une des revendications précédentes, **caractérisé en ce que** le mélange introduit dans la chambre de réaction est introduit via un passage (20) débouchant sur l'intervalle (22) séparant les deux électrodes (10, 12).

4. Procédé selon l'une des revendications précédentes, **caractérisé en ce que** le plasma est généré de part et d'autre du substrat (4) entre les deux électrodes (10, 12) et l'au moins une contre-électrode (13, 14, 15), de façon à obtenir un traitement de surface de chaque côté du substrat (2).

5. Procédé selon la revendication 4, **caractérisé en ce que** des mélanges réactifs (18, 19) ayant des compositions différentes sont introduits dans la chambre de réaction (2) de part et d'autre du substrat (4), de manière à obtenir un traitement de surface différent de chaque côté du substrat (4).

6. Procédé selon l'une des revendications précédentes, **caractérisé en ce que** deux contre-électrodes (13, 15) faisant face aux deux électrodes (10, 12) sont placées côte à côte et **en ce que** le mélange réactif (19) est introduit via un passage (26) dans la chambre de réaction débouchant sur l'intervalle (28) séparant les deux contre-électrodes (13,15).

7. Procédé selon l'une des revendications précédentes, **caractérisé en ce qu'**il comprend en outre les opérations suivantes :
- mettre en service une inductance ajustable (L) disposée en parallèle avec l'inductance propre de l'installation engendrant la tension électrique, de façon à réduire le déphasage entre la tension et le courant engendré ;
- adapter la tension et/ou la fréquence fournies par le circuit générateur et/ou la valeur ajustable (L) de l'inductance au début ou en cours de procédé, de façon à augmenter le rapport puissance active/puissance réactive.

8. Procédé selon la revendication 7, **caractérisé en ce qu'**il comprend en outre l'opération suivante :
- adapter la tension et/ou la fréquence fournies par le circuit générateur et/ou la valeur ajustable (L) de l'inductance de façon à favoriser la production d'harmoniques prolongeant le temps durant lequel la tension reste supérieure à la valeur de maintien de la décharge électrique.

9. Procédé selon la revendication 8, **caractérisé en ce que** l'on favorise essentiellement les harmoniques d'ordre 3 et 5.

10. Procédé selon l'une quelconque des revendications précédentes, **caractérisé en ce qu'**il comprend en outre l'opération suivante :
- amener l'atmosphère régnant dans la chambre à une pression inférieure à la pression atmosphérique.

11. Procédé selon l'une quelconque des revendications précédentes, **caractérisé en ce que** la chambre (2) est ouverte et comprend une zone d'entrée et une zone de sortie pour le substrat (4).

12. Procédé selon l'une quelconque des revendications précédentes, **caractérisé en ce que** le substrat (4) est isolant et constitue lui-même au moins une des barrières diélectriques (16).

13. Installation adaptée au traitement de surface d'un substrat (4) par décharge à barrière diélectrique (DBD) comprenant une chambre (2), des moyens de transport et de support pour introduire le substrat (4) dans la chambre, une alimentation électrique à haute tension et à haute fréquence, deux électrodes (10, 12) et au moins une contre-électrode (13, 14, 15), ladite alimentation électrique étant reliée auxdites deux électrodes (10, 12) et à ladite au moins une contre-électrode (13, 14, 15), lesdites deux électrodes (10, 12) et ladite au moins une contre-électrode (13, 14, 15) étant disposées de part et d'autre des moyens de transport et de support du substrat (4), au moins une barrière diélectrique (16, 16a, 16b) disposée entre les deux électrodes (10, 12) et l'au moins une contre-électrode (13, 14, 15), des moyens de régulation et de contrôle de l'alimentation électrique, des moyens d'introduction de substances réactives dans la chambre (2), des moyens d'extraction de substances résiduelles, cette installation étant adaptée à générer un plasma pour le traitement de surface du substrat (4),
**caractérisée en ce que** l'installation comprend en outre deux inductances (L1, L2), chacune des inductances étant branchée en série avec chacune desdites deux électrodes (10, 12), la valeur desdites inductances (L1, L2) étant telle que dans le cas où le plasma s'allume sous une seule électrode, le courant circulant dans l'inductance en série avec cette électrode induise un flux magnétique dans l'autre inductance, et que la tension en résultant aux bornes de cette seconde inductance provoque une augmentation de la tension aux bornes de l'électrode restée éteinte forçant l'allumage de celle-ci, lesdites deux inductances étant bobinées sur un noyau magnétique commun de manière à ce que le flux magnétique résultant des deux inductances soit nul lorsque des courants identiques circulent dans les deux électrodes.

14. Installation de traitement de surface selon la revendication 13, **caractérisée en ce que** le plasma est généré dans deux zones distinctes disposées de part et d'autre du substrat, de sorte qu'un traitement est effectué sur chacune des faces de ce substrat (2) simultanément.

15. Installation adaptée au traitement de surface d'un substrat (4) par décharge à barrière diélectrique (DBD) comprenant deux chambres (2a, 2b), chaque chambre comprenant deux électrodes (10a, 12a, 10b, 12b) et au moins une contre-électrode (13a, 15a, 13b, 15b), des moyens de transport et de support pour introduire le substrat (4) dans les chambres, une alimentation électrique à haute tension et haute fréquence unique reliée auxdites électrodes (10a, 12a) et à ladite au moins une contre-électrode (13a, 15a) dans la première chambre (2a), et auxdites deux électrodes (10b, 12b) et à ladite au moins une contre-électrode (13b, 15b) dans la seconde chambre (2b), lesdites quatre électrodes (10a, 12a, 10b, 12b) et lesdites au moins deux contre-électrodes (13a, 15a, 13b, 15b) étant disposées de part et d'autre des moyens de transport et de support du substrat (2), au moins une barrière diélectrique disposée entre les quatre électrodes (10a, 12a, 10b, 12b) et les au moins deux contre-électrodes (13a, 15a, 13b, 15b), des moyens de régulation et de contrôle de l'alimentation électrique, des moyens d'introduction de substances réactives dans les chambres, des moyens d'extraction de substances résiduelles, cette installation étant adaptée à générer un plasma pour le traitement de surface du substrat (4) dans chaque chambre,
l'installation comprenant en outre des inductances principales (L1, L2 et L3, L4) et des inductances secondaires (L5, L6) telles que, pour chaque chambre séparément, chacune desdites inductances principales (L1, L2 et L3, L4) sont branchées en série avec chacune desdites électrodes, la valeur desdites inductances principales (L1, L2 et L3, L4) étant telle que dans le cas où le plasma s'allume sous une seule électrode, le courant circulant dans l'inductance principale en série avec cette électrode induise un flux magnétique dans l'autre inductance principale, et que la tension en résultant aux bornes de cette autre inductance principale provoque une augmentation de la tension aux bornes de l'électrode restée éteinte forçant l'allumage de celle-ci, lesdites inductances principales étant bobinées sur un noyau magnétique commun de manière à ce que le flux magnétique résultant des deux inductances principales soit nul lorsque des courants identiques circulent dans les deux électrodes,
et lesdites inductances secondaires (L5, L6) étant branchées en série avec lesdites inductances principales, la valeur desdites inductances secondaires supplémentaires (L5, L6) étant telle que le courant circulant dans la première inductance secondaire en série avec la première chambre induise un flux magnétique dans l'autre inductance secondaire, et que la tension en résultant aux bornes de cette autre inductance secondaire assure l'équilibrage des tensions entre les deux chambres, lesdites inductances secondaires étant bobinées sur un noyau magnétique commun de manière à ce que le flux magnétique résultant des deux inductances secondaires soit nul lorsque des courants identiques circulent dans les deux chambres.
